# EUROPÄISCHE PATENTSCHRIFT

(11) **EP 0 946 991 B1**
(45) Veröffentlichungstag und Bekanntmachung des Hinweises auf die Patenterteilung: **22.03.2006**
(21) Anmeldenummer: 97932748.3
(22) Anmeldetag: 08.07.1997
(51) Int. Cl.: H01L 29/792

(54) **NICHTFLÜCHTIGE SPEICHERZELLE**
NON-VOLATILE STORAGE CELL
CELLULE MEMOIRE NON VOLATILE

(30) Priorität: 01.08.1996 DE 19631146
(43) Veröffentlichungstag der Anmeldung: 06.10.1999
(73) Patentinhaber: Infineon Technologies AG, 81669 München (DE)
(72) Erfinder: REISINGER, Hans, D-82031 Grünwald (DE); STENGL, Reinhard, D-86391 Stadtbergen (DE); GRÜNING, Ulrike, Hopewell Junction, NY 12533 (US); WENDT, Hermann, D-85630 Grasbrunn (DE); WILLER, Josef, D-85521 Riemerling (DE); LEHMANN, Volker, D-80689 München (DE); FRANOSCH, Martin, D-81739 München (DE); SCHÄFER, Herbert, D-85635 Höhenkirchen-Siegertsbrunn (DE); KRAUTSCHNEIDER, Wolfgang, D-82104 Hohenthann (DE); HOFMANN, Franz, D-80995 München (DE)
(74) Vertreter: Epping - Hermann - Fischer
(86) Internationale Anmeldenummer: PCT/DE1997/001431
(87) Internationale Veröffentlichungsnummer: WO 1998/006138

(56) Entgegenhaltungen:
- EP-A- 0 597 124
- US-A- 4 151 537
- US-A- 5 311 049
- US-A- 5 436 481

## Beschreibung

Zur dauerhaften Speicherung von Daten sind nichtflüchtige Speicherzellen, sogenannte SONOS-Zellen oder MNOS-Zellen, vorgeschlagen worden, die jeweils einen speziellen MOS-Transistor umfassen (siehe zum Beispiel Lai et al, IEDM Tech. Dig. 1986, Seite 580 bis 583). Der MOS-Transistor umfaßt ein Gatedielektrikum, das mindestens eine Siliziumnitridschicht unterhalb der Gateelektrode und eine SiO₂-Schicht zwischen der Siliziumnitridschicht und dem Kanalbereich umfaßt. Zur Speicherung der Information werden Ladungsträger in der Siliziumnitridschicht gespeichert.

Die Dicke der SiO₂-Schicht beträgt in diesen nichtflüchtigen Speicherzellen maximal 2,2 nm. Die Dicke der Si₃N₄-Schicht beträgt in modernen SONOS-Speichern üblicherweise etwa 10 nm. Zwischen der Siliziumnitridschicht und der Gateelektrode ist meist eine weitere SiO₂-Schicht vorgesehen, die eine Dicke von 3 bis 4 nm aufweist. Diese nichtflüchtigen Speicherzellen sind elektrisch schreib- und löschbar. Beim Schreibvorgang wird an die Gateelektrode eine solche Spannung angelegt, daß Ladungsträger aus dem Substrat durch die maximal 2,2 nm dicke SiO₂-Schicht in die Siliziumnitridschicht tunneln. Zum Löschen wird die Gateelektrode so beschaltet, daß die in der Siliziumnitridschicht gespeicherten Ladungsträger durch die maximal 2,2 nm dicke SiO₂-Schicht in den Kanalbereich tunneln und aus dem Kanalbereich Ladungsträger vom entgegengesetzten Leitfähigkeitstyp durch die SiO₂-Schicht in die Siliziumnitridschicht tunneln. Gleichzeitig tunneln Ladungsträger vom ersten Leitfähigkeitstyp aus der Gateelektrode in die Siliziumnitridschicht. Die Schichtdicken werden so bemessen, daß der Ladungsträgertransport zum Kanalbereich im Vergleich zum Ladungsträgertransport aus der Gateelektrode überwiegt. Für den Löschvorgang sind typischerweise Zeiten von 100 ms erforderlich.

In der US 5,436,481 ist ein MOS-Transistor beschrieben, bei dem als Gate-Dielektrikum eine Oxid-Nitrid-Oxid-Schichtfolge vorhanden ist. Die Siliziumnitridschicht besitzt eine Dicke von 4,5 nm bis 14,86 nm. Bei einem angegebenen Ausführungsbeispiel sind die Siliziumoxidschichten jeweils 3 nm dick. Es wird in der Beschreibung darauf hingewiesen, dass die Struktur des Gate-Dielektrikums einen für einen Betrieb des Bauelementes als Transistor unerwünschten Einfang von Elektronen in der Nitridschicht ermöglicht, was einem Betrieb des Bauelementes als Speicherbauelement entspricht. Es werden Betriebsbedingungen angegeben, wie eine solche unerwünschte Betriebsweise vermieden werden kann. Es wird ferner darauf hingewiesen, dass die Gate-Elektrode p-dotiertes Polysilizium sein kann. Angaben zur Optimierung einer Speicherfunktion finden sich in dieser Schrift nicht.

In der US 4,151,537 ist ein MNOS-Halbleiterspeicherbauelement angegeben, bei dem eine für Ladungsträgereinfang vorgesehene Schichtfolge als Gate-Dielektrikum vorgesehen ist und die Gate-Elektrode aus p-leitend dotiertem Polysilizium sein kann.

In der US 5,311,049 ist eine nicht-flüchtige Speicherzelle zum Programmieren durch Ladungsträgereinfang als MONOS-Element beschrieben, das eine untere Tunneloxidschicht mit einer Dicke von 2 nm bis 6 nm aufweist, eine Nitridspeicherschicht mit einer Dicke von 6 nm bis 12 nm sowie eine obere Oxidschicht mit einer Dicke von 4nm bis 8 nm.

Die SONOS-Zellen weisen eine Zeit für den Datenerhalt von 5 10 Jahren auf. Diese Zeit ist für viele Anwendungen, zum Beispiel für die Speicherung von Daten in Computern, zu kurz.

Für Anwendungen, in denen längere Zeiten für den Datenerhalt gefordert werden, ist es bekannt, als nichtflüchtige Speicher EEPROM-Zellen mit floating gate zu verwenden. In diesen Speicherzellen, die zum Beispiel aus Lai et al, IEDM Tech. Dig. 1986, Seite 580 bis 583 bekannt sind, ist zwischen einer Kontrollgateelektrode und dem Kanalbereich des MOS-Transistors eine Floating Gate Elektrode angeordnet, die vollständig von dielektrischem Material umgeben ist. Auf der Floating Gate Elektrode wird die Information in Form von Ladungsträgern gespeichert. Diese Speicherzellen, die auch als FLOTOX-Zellen bezeichnet werden, sind elektrisch schreib- und löschbar. Dazu wird die Steuergateelektrode mit einem solchen Potential verbunden, das Ladungsträger aus dem Kanalbereich auf die Floating Gate Elektrode fließen (Schreiben) bzw. Ladungsträger von der Floating Gate Elektrode in den Kanalbereich flie-βen (Löschen). Der Löschvorgang in FLOTOX-Zellen erfordert Zeiten von typisch 100 ms. Die FLOTOX-Zellen weisen Zeiten für den Datenerhalt größer als 150 Jahre auf.

Im Vergleich zu den SONOS-Zellen sind sie jedoch kompliziert im Aufbau. Ferner ist der Platzbedarf der FLOTOX-Zellen im Vergleich zu den SONOS-Zellen größer, da die Steuergateelektrode die Floating Gate Elektrode seitlich überlappen muß. Schließlich ist die sogenannten Radiation hardness von FLOTOX-Zellen begrenzt. Unter Radiation hardness wird die Unempfindlichkeit der gespeicherten Ladung gegenüber äußeren Strahlungsquellen und/oder elektromagnetischen Feldern bezeichnet.

Der Erfindung liegt das Problem zugrunde, eine nichtflüchtige Speicherzelle anzugeben, die für den Löschvorgang Zeiten unter 1 s benötigen, die einfach aufgebaut ist und in großer Packungsdichte integriert werden kann und die im Vergleich zu den FLOTOX-Zellen eine verbesserte Radiation hardness aufweist.

Dieses Problem wird erfindungsgemäß gelöst durch eine Speicherzelle nach Anspruch 1. Weitere Ausgestaltungen gehen aus den Unteransprüchen hervor.

Die nichtflüchtige Speicherzelle umfaßt einen MOS-Transistor mit Sourcegebiet, Kanalbereich, Draingebiet, Gatedielektrikum und Gateelektrode, der als Gatedielektrikum eine dielektrische Dreifachschicht aufweist. Die dielektrische Dreifachschicht umfaßt eine erste Siliziumoxidschicht, eine Siliziumnitridschicht und eine zweite Siliziumoxidschicht. Die Siliziumnitridschicht ist zwischen den beiden Siliziumoxidschichten angeordnet. Die Gateelektrode enthält p⁺-dotiertes Silizium.

Von konventionellen SONOS-Zellen unterscheidet sich die erfindungsgemäße Speicherzelle dadurch, daß die Gateelektrode p⁺-dotiertes Silizium enthält. Im Vergleich zu n-dotiertem Silizium oder Metall, das als Gateelektrode in konventionellen SONOS-Zellen verwendet wird, ist im Idealfall durch die p⁺-Dotierung die Besetzungswahrscheinlichkeit von elektronischen Zuständen in der Gateelektrode um etwa den Faktor 10²⁰ reduziert. Beim Löschvorgang können daher keine Elektronen aus der Gateelektrode in die Siliziumnitridschicht tunneln. Der Löschvorgang der erfindungsgemäßen Speicherzelle erfolgt daher über Tunneln von Löchern aus dem Kanalbereich durch die erste Siliziumoxidschicht in die Siliziumnitridschicht und durch Tunneln von Elektronen aus der Siliziumnitridschicht in den Kanalbereich. Bei konventionellen SONOS-Zellen tunneln zusätzlich Elektronen aus der Gateelektrode in die Siliziumnitridschicht, die beim Löschvorgang ebenfalls neutralisiert werden müssen. Dieser Elektronenstrom wird in der erfindungsgemäßen Speicherzelle dadurch unterdrückt, daß die Zahl der Elektronen in der Gateelektrode durch die Verwendung von p⁺⁻dotiertem Silizium reduziert ist. Die Zeit für den Löschvorgang ist in der erfindungsgemäßen Speicherzelle gegenüber konventionellen Speicherzellen um einen Faktor von ca. 10⁵ reduziert.

Weiterhin wird die Erkenntnis ausgenutzt, daß die Tunnelwahrscheinlichkeit für direktes Tunneln mit zunehmender Dicke der ersten Siliziumoxidschicht stark abnimmt und bei einer Dicke von mindestens 3 nm sehr klein ist.

Da in der erfindungsgemäßen Speicherzelle die erste Siliziumoxidschicht und die zweite Siliziumoxidschicht jeweils mindestens 3 nm dick sind, wird in dieser Speicherzelle ein Ladungsträgertransport aus der Siliziumnitridschicht zur Gateelektrode oder zum Kanalbereich durch direktes Tunneln weitgehend vermieden. Das heißt, in der Siliziumnitridschicht gespeicherte Ladung bleibt praktisch unbegrenzt erhalten. Die Zeit für den Datenerhalt ist in der erfindungsgemäßen Speicherzelle daher deutlich größer als in konventionellen SONOS-Zellen.

Vorzugsweise werden die Dicken der ersten Siliziumoxidschicht und der zweiten Siliziumoxidschicht in der erfindungsgemäßen Speicherzelle so gewählt, daß sie sich um einen Betrag im Bereich zwischen 0,5 und 1 nm unterscheiden. Die geringere der beiden Dicken der ersten Siliziumoxidschicht und der zweiten Siliziumoxidschicht liegt dabei im Bereich zwischen 3 und 5 nm. Die Dicke der Siliziumnitridschicht beträgt mindestens 5 nm. In dieser Ausführungsform ist die dielektrische Dreifachschicht elektrisch symmetrisch. Durch die unterschiedlichen Dicken der ersten Siliziumoxidschicht und der zweiten Siliziumoxidschicht werden die Austrittsarbeitsunterschiede zwischen dem Kanalbereich und der Gateelektrode und hauptsächlich die beim Lesebetrieb anliegende, im allgemeinen positive Gatespannung berücksichtigt.

Da die Dicken der ersten Siliziumoxidschicht und der zweiten Siliziumoxidschicht jeweils mindestens 3 nm betragen, ist die Tunnelwahrscheinlichkeit für direktes Tunneln von Ladungsträgern durch die beiden Siliziumoxidschichten sehr klein. Der Ladungsträgertransport findet beim Schreiben und Lesen nur durch Fowler-Nordheim-Tunneln durch die erste Siliziumoxidschicht bzw. zweite Siliziumoxidschicht statt. Die Stromstärke des Ladungsträgertransports durch Fowler-Nordheim-Tunneln hängt nur von der Stärke des anliegenden elektrischen Feldes ab. Er ist nicht explizit abhängig von der Dicke der Tunnelbarriere, das heißt der Dicke der ersten Siliziumoxidschicht bzw. zweiten Siliziumoxidschicht.

Bei Anlegen einer positiven Spannung an die Gateelektrode überwiegt das Fowler-Nordheim-Tunneln von Elektronen aus dem Kanalbereich durch die erste Siliziumoxidschicht in die Siliziumnitridschicht. Durch Anlegen einer positiven Spannung an die Gateelektrode wird Information in die Speicherzelle eingeschrieben. Da in der Gateelektrode wegen der Verwendung von p⁺-dotiertem Silizium die Zahl der Elektronen reduziert ist, überwiegt bei Anliegen einer negativen Spannung an die Gateelektrode das Fowler-Nordheim-Tunneln von Löchern aus dem Kanalbereich durch die erste Siliziumoxidschicht in die Siliziumnitridschicht. Aufgrund der Potentialverhältnisse wäre zwar das Fowler-Nordheim-Tunneln von Elektronen aus der Gateelektrode durch die zweite Siliziumoxidschicht in die Siliziumnitridschicht energetisch günstiger, da jedoch in der Gateelektrode die Zahl der Elektronen reduziert ist, ist der Fowler-Nordheim-Tunnelstrom von Elektronen von der Gateelektrode in die Siliziumnitridschicht vernachlässigbar. Durch Anlegen einer negativen Spannung an die Gateelektrode wird daher die in der Siliziumnitridschicht in Form von Elektronen gespeicherte Information durch das Tunneln von Löchern aus dem Kanalbereich durch die erste Siliziumoxidschicht in die Siliziumnitridschicht gelöscht. Zum Einschreiben bzw. Löschen von Informationen ist ein Spannungspegel von etwa ± 10 V erforderlich. Die Zeiten, die für den Löschvorgang benötigt werden, liegen typischerweise bei 100 ms.

Da in dieser Speicherzelle die Wahrscheinlichkeit für direktes Tunneln durch die erste Siliziumoxidschicht und die zweite Siliziumoxidschicht vernachlässigbar ist, beträgt die Zeit für den Datenerhalt in der Speicherzelle mehr als tausend Jahre.

Zum Einschreiben von Information in diese Speicherzelle wird eine Spannung von + 10 V angelegt. Zum Lesen der Information wird eine Spannung von 3 V angelegt.

Soll die Speicherzelle mit positiver Lesespannung betrieben werden, so weist die erste Siliziumoxidschicht eine geringere Dicke als die zweite Siliziumoxidschicht auf. Soll die Speicherzelle mit negativer Lesespannung betrieben werden, so weist die zweite Siliziumoxidschicht eine geringere Dicke als die erste Siliziumoxidschicht auf.

Die Speicherzelle wird, wie allgemein üblich, in Speicherzellenanordnungen integriert, die matrixförmig eine Vielzahl identischer Speicherzellen aufweist.

Da die Speicherzelle keine Floating Gate Elektrode aufweist, ist ihre Radiation hardness größer als für die vergleichbare FLOTOX-Zelle. Der MOS-Transistor in der Speicherzelle kann sowohl als planarer als auch als vertikaler MOS-Transistor ausgebildet werden.

Im folgenden wird die Erfindung anhand der Ausführungsbeispiele und der Figuren näher erläutert.
- Figur 1: zeigt eine Speicherzelle mit einem planaren MOS-Transistor.
- Figur 2: zeigt eine Speicherzelle mit einem vertikalen MOS-Transistor.

In einem Substrat 1, das mindestens im Bereich einer Speicherzelle monokristallines Silizium umfaßt, sind ein Sourcegebiet 2 und ein Draingebiet 3, die zum Beispiel n-dotiert sind, vorgesehen. Zwischen dem Sourcegebiet 2 und dem Draingebiet 3 ist ein Kanalbereich 4 angeordnet. Oberhalb des Kanalbereichs 4 ist eine dielektrische Dreifachschicht 5 angeordnet, die eine erste SiO₂-Schicht 51, eine Si₃N₄-Schicht 52 und eine zweite SiO₂-Schicht 53 umfaßt. Die erste SiO₂₋Schicht 51 ist an der Oberfläche des Kanalbereichs 4 angeordnet und weist eine Dicke von 3 bis 5 nm, vorzugsweise 4 nm auf. An der Oberfläche der ersten SiO₂-Schicht 51 ist die Si₃N₄-Schicht 52 angeordnet. Sie weist eine Dicke von mindestens 5 nm, vorzugsweise 8 nm auf. An der Oberfläche der Si₃N₄-Schicht 52 ist die zweite SiO₂-Schicht 53 angeordnet, deren Dicke um 0,5 bis 1 nm größer als die Dicke der ersten SiO₂-Schicht 51 ist, das heißt im Bereich zwischen 3,5 und 6 nm, vorzugsweise bei 4,5 bis 5 nm liegt.

Auf der Oberfläche der dielektrischen Dreifachschicht 5 ist eine Gateelektrode 6 aus p⁺-dotiertem Polysilizium angeordnet. Die Gateelektrode 6 weist eine Dicke von zum Beispiel 200 nm und eine Dotierstoffkonzentration von zum Beispiel 5 x 10²⁰ cm⁻³ auf.

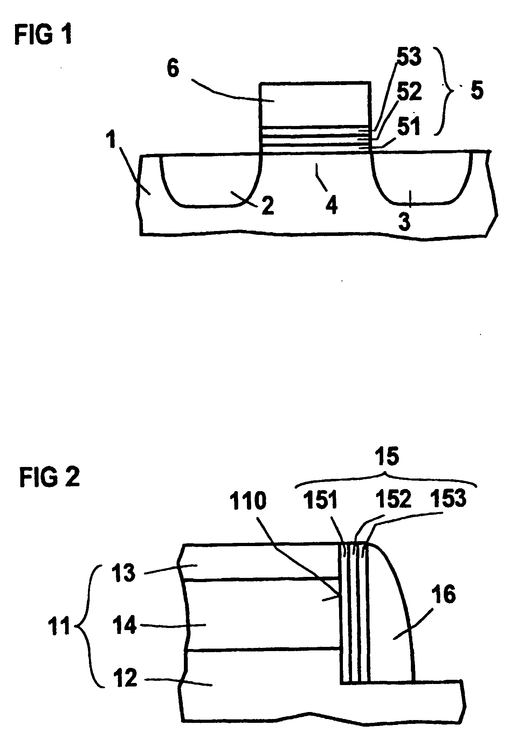

Ein Halbleiterschichtaufbau 11 aus zum Beispiel monokristallinem Silizium umfaßt in vertikaler Aufeinanderfolge ein Sourcegebiet 12, ein Kanalgebiet 14 und ein Draingebiet 13 (siehe Figur 2). Das Sourcegebiet 12 und das Draingebiet 13 sind zum Beispiel n-dotiert mit einer Dotierstoffkonzentration von 10²¹ cm⁻³. Das Kanalgebiet 14 ist zum Beispiel p-dotiert mit einer Dotierstoffkonzentration von 10¹⁷ cm⁻³. Das Sourcegebiet 12, das Draingebiet 13 und das Kanalgebiet 14 weisen eine gemeinsame Flanke 110 auf, die vorzugsweise senkrecht oder leicht geneigt zur Oberfläche des Halbleiterschichtaufbaus 11 verläuft. Die Flanke 110 kann sowohl die Flanke eines Grabens oder einer Stufe in einem Substrat als auch die Flanke einer erhabenen Struktur, zum Beispiel einer Mesastruktur sein.

An der Flanke 110 ist eine dielektrische Dreifachstruktur 15 angeordnet, die eine erste SiO₂-Schicht 151, eine Si₃N₄₋Schicht 152 und eine zweite SiO₂-Schicht 153 umfaßt. Die Oberfläche der zweiten SiO₂-Schicht 153 ist mit einer Gateelektrode 16 bedeckt. Die Gateelektrode 16 ist zum Beispiel in Form eines Spacers aus p⁺-dotiertem Polysilizium mit einer Dotierstoffkonzentration von 5 x 10²⁰ cm⁻³ gebildet. Die zweite SiO₂-Schicht 153 weist eine Dicke von zum Beispiel 3 bis 5 nm, vorzugsweise 4 nm auf. Die Si₃N₄-Schicht 152 weist eine Dicke von mindestens 5 nm, vorzugsweise 8 nm auf. Die erste SiO₂-Schicht 151 ist um 0,5 bis 1 nm dicker als die zweite SiO₂-Schicht 153, das heißt, sie weist eine Dicke zwischen 3,5 und 6 nm auf. Vorzugsweise weist sie eine Dicke von 4,5 nm auf. Die Dicken der ersten SiO₂-Schicht 151, der Si₃N₄-Schicht 152 sowie der zweiten SiO₂-Schicht 153 sind jeweils senkrecht zur Flanke 110 gemessen.

## Patentansprüche

1. Nichtflüchtige Speicherzelle
- mit einem MOS-Transistoren, der als Gatedielektrikum eine dielektrische Dreifachschicht (5) mit einer ersten Siliziumoxidschicht (51), einer Siliziumnitridschicht (52) und einer zweiten Siliziumoxidschicht (53) aufweist,
- bei der die erste Siliziumoxidschicht (51) und die zweite Siliziumoxidschicht (53) jeweils mindestens 3 nm dick sind und
- die Dicke der Siliziumnitridschicht (52) mindestens 5 nm beträgt,
- wobei der MOS-Transistor eine Gateelektrode (6) aufweist, die p⁺-dotiertes Silizium enthält,
**dadurch gekennzeichnet, dass**
- die Differenz der Dicken der ersten Siliziumoxidschicht (51) und der zweiten Siliziumoxidschicht (53) im Bereich zwischen 0,5 nm und 1 nm liegt und
- die geringere der Dicken der ersten Siliziumoxidschicht (51) und der zweiten Siliziumoxidschicht (53) im Bereich zwischen 3 und 5 nm liegt.

2. Nichtflüchtige Speicherzelle nach Anspruch 1,
bei der das p⁺-dotierte Silizium in der Gateelektrode (6) eine Dotierstoffkonzentration von mindestens 1 x 10²⁰ cm⁻³ aufweist.

3. Nichtflüchtige Speicherzelle nach Anspruch 1 oder 2,
bei der die dielektrische Dreifachschicht (15) an einer Flanke eines Halbleiterschichtaufbaus aus einem Sourcegebiet (12), einem Kanalgebiet (14) und einem Draingebiet (13) angeordnet ist.

## Claims

1. Non-volatile memory cell
- with a MOS transistor whose gate dielectric takes the form of a dielectric triple layer (5) with a first silicon oxide layer (51), a silicon nitride layer (52) and a second silicon oxide layer (53),
- in which the first silicon oxide layer (51) and the second silicon oxide layer (53) each have a thickness of at least 3 nm,
- the thickness of the silicon nitride layer (52) is at least 5 nm,
- the MOS transistor having a gate electrode (6), which contains p⁺-doped silicon,
**characterized in that**
- the difference between the thicknesses of the first silicon oxide layer (51) and the second silicon oxide layer (53) lies in the range between 0.5 nm and 1 nm, and
- the smaller of the thicknesses of the first silicon oxide layer (51) and of the second silicon oxide layer (53) lies in the range between 3 and 5 nm.

2. Non-volatile memory cell according to Claim 1, in which the p⁺-doped silicon in the gate electrode (6) has a doping concentration of at least 1 x 10²⁰ cm⁻³.

3. Non-volatile memory cell according to Claim 1 or 2,
in which the dielectric triple layer (15) is arranged at a sidewall of a semiconductor layer construction comprising a source region (12) a channel region (14) and a drain region (13).

## Revendications

1. Cellule de mémoire non volatile
- comprenant un transistor MOS qui a, comme diélectrique de grille, une couche (5) diélectrique triple ayant une première couche (51) d'oxyde de silicium, une couche (52) de nitrure de silicium et une deuxième couche (53) d'oxyde de silicium,
- dans laquelle la première couche (51) d'oxyde de silicium et la deuxième couche (53) d'oxyde de silicium ont chacune une épaisseur d'au moins 3 nm, et
- l'épaisseur de la couche (52) de nitrure de silicium est d'au moins 5 nm,
- dans laquelle le transistor MOS a une électrode (6) de grille qui contient du silicium à dopage p⁺,
**caractérisée en ce que**
- la différence des épaisseurs de la première couche (51) d'oxyde de silicium et de la deuxième couche (53) d'oxyde de silicium est dans la plage comprise entre 0,5 nm et 1 nm, et
- la plus petite des épaisseurs de la première couche (51) d'oxyde de silicium et de la deuxième couche (53) d'oxyde de silicium est dans la plage comprise entre 3 et 5 nm.

2. Cellule de mémoire non volatile suivant la revendication 1, dans laquelle le silicium à dopage p⁺ de l'électrode (6) de grille a une concentration de substance de dopage d'au moins 1 x 10²⁰ cm⁻³.

3. Cellule de mémoire non volatile suivant la revendication 1 ou 2, dans laquelle la couche (15) diélectrique triple est disposée sur un flanc d'une structure de couches de semi-conducteurs constituée d'une zone (12) de source, d'une zone (14) de canal et d'une zone (13) de drain.
